Europäisches Patentamt

European Patent Office

Office européen des brevets

(11) Publication number : **0 571 142 A1**

(12) **EUROPEAN PATENT APPLICATION**

(21) Application number : 93303751.7

(22) Date of filing : 14.05.93

(51) Int. Cl.⁵ : **H01L 31/107, H01L 31/0288**

(30) Priority : 18.05.92 US 884443

(43) Date of publication of application :
24.11.93 Bulletin 93/47

(84) Designated Contracting States :
**DE GB NL**

(71) Applicant : **GENERAL ELECTRIC COMPANY**
**1 River Road**
**Schenectady, NY 12345 (US)**

(72) Inventor : **Ishaque, Ahmad Nadeem**
**2302 Huntridge Drive**
**Clifton Park, New York 12065 (US)**

(74) Representative : **Lupton, Frederick et al**
**LONDON PATENT OPERATION, G.E.**
**TECHNICAL SERVICES Co. INC., Essex**
**House, 12/13 Essex Street**
**London WC2R 3AA (GB)**

(54) Platinum doped silicon avalanche photodiode.

(57)    An avalanche photodiode (APD) has a first semiconductor layer (110) that is doped to exhibit p type conductivity and a second semiconductor layer (120) that is doped to exhibit n type conductivity. The first and second semiconductor layers are disposed adjacent to one another to form a p-n junction (130). The first and second semiconductor layers further have a deep level lifetime-reducing dopant that has relatively large carrier cross sections distributed therethrough. Platinum is used as the lifetime reducing dopant. The platinum-doped semiconductor layers exhibit at least one recombination center located between about 100 mV and 450 mV from the center of the energy bandgap. The platinum-doped APD exhibits lower low level and high level lifetimes than a non-doped silicon APD and further does not exhibit an increased bulk leakage current.

FIG. 1

EP 0 571 142 A1

## Background of the Invention

This invention relates generally to solid state light detection systems and more particularly to avalanche photodiodes.

Photodiodes commonly used for converting light energy into corresponding electrical signals comprise one or more layers of photosensitive material doped to exhibit alternately p or n type conductivity, in which free holes and electrons are generated in response to incident light. The photosensitive material is a semiconductor and is disposed between electrodes. Dependent on device design, free electrons or holes are predominantly collected at one or the other of the electrodes. The amount of charge collected is dependent (in part, at least) on the flux of the incident light, thus providing an electrical signal corresponding to the intensity of the incident light.

Avalanche photodiodes (APDs) are used to detect low intensity light and still produce electrical signals of sufficient magnitude to be readily used in most electrical processing circuitry. Typically APDs exhibit an internal amplification of 10 to 500 times the original electrical signal generated solely by the absorption of the incident light.

Desirable characteristics of an APD include high gain, low dark current (and related noise), and high switching speed, i.e., the ability to temporally discriminate between successive pulses of incident light. Gain is a function of the doping level of the material selected to form the APD and the biasing voltages applied to the particular APD structure. The level of dark current and switching speed in an APD depend on several characteristics of the semiconductor material used in fabricating the APD, namely the low-level lifetime, the high level lifetime, and the space charge lifetime of carriers in the photosensitive materials.

Low level lifetime, also known as minority carrier lifetime, refers to the excess minority carrier lifetime at low levels of injection, that is when there is little incident light and thus the concentration of injected carriers is a small fraction of the equilibrium majority carrier concentration. In a sufficiently n type semiconductor material, minority carrier lifetime is referred to as $\tau_{po}$ ; in a sufficiently p type semiconductor material it is referred to as $\tau_{no}$.

High level lifetime refers to the excess carrier lifetime at high level injection (i.e., high flux of incident light), when the injected carrier concentration is much larger than the equilibrium majority carrier concentration. For materials in which recombination takes place primarily through a single recombination center located near the center of the energy bandgap, the high level lifetime is the sum of $\tau_{po}$ and $\tau_{no}$ (the respective low level lifetimes for the for the n- and p-type semiconductors forming the p-n junction). Even in materials that exhibit multiple recombination levels, a single dominant recombination level is commonly used for analyzing the characteristics of the material.

Space charge lifetime is the lifetime corresponding to charge generation in the space charge region (depletion layer) in a doped semiconductor material. Space charge lifetime is a function of the separation between the recombination level $E_r$ and the intrinsic level $E_i$, and is given by $E_r$- $E_i$.

The switching speed (i.e., the time it takes the charge resulting from the detection of a light pulse to "die down") of the device at low levels of light energy is determined by the low level lifetime of the photosensitive material. At higher levels of excitation, e.g., with a high flux of incident light energy, the switching speed is a function of the high level lifetime of the photosensitive material. Thus lower values of $\tau_{po}$ and $\tau_{no}$ indicate faster device switching speeds. Dark current is inversely proportional to the space charge generation lifetime.

Intrinsic silicon doped to exhibit p or n type characteristics is typically used in making APDs as it is readily fabricated and integrated in arrays with associated processing circuitry, such as scan and data lines and thin film transistors. The minority carrier and high level lifetime of carriers in silicon, however, are each relatively large and thus an APD in which the photosensitive material is substantially intrinsic silicon has relatively slow switching times. No lifetime-reducing dopants are currently used in fabricating silicon APDs because the increased dark current resulting when typical lifetime-reducing dopants are introduced in silicon would make the use of such a doped APD impractical. Minimization of dark current is a critical parameter in the APD art as the very nature of APDs and their employment to detect low light levels make any source of noise a critical detriment to APD operation.

Gold is commonly used as a dopant in the power device art to modify the recombination characteristics of semiconductor materials used in devices such as thyristors. Use of gold as a deep level dopant modifies the recombination characteristics of carriers in silicon and improves switching speeds in the power device. The addition of gold increases the leakage current, but this typically is not of particular importance in a power device. Gold is not used as a dopant in APD technologies as the increased dark current severely degrades device performance. Additionally, gold-doped semiconductor materials are electrically unstable at temperatures above about 150 ° C, and APDs are typically exposed to temperatures up to about 300° C in the fabrication process of arrays in which APDs are used.

In the power device art, analysis has been conducted on ways to reduce carrier lifetimes using various types of dopants, including platinum (Pt), as appears in the following representative articles: "Optimization of Recombination Levels and Their Capture Cross Section in Power Rectifiers and Thyristors" by B.J. Baliga and S. Krishna, Solid-State Electronics, Vol. 20, 1977, pp 225-232; "Differences Between Platinum- and Gold-Doped Silicon Power Devices", by M. Miller, IEEE Transactions on Electron Devices, Vol. ED-23, December 1976, pp 1279-1283; and Platinum as a lifetime-control deep impurity in silicon", by K.P. Lisiak and A.G. Milnes, Journal of Applied Physics, Vol. 46, December 1975, pp. 5229-5235, each of which is incorporated herein by reference. The platinum doping provides reduced leakage at high temperatures, and exhibits different recombination lifetime values dependent on the level of injection. The advantage of platinum or gold in power devices is relative and depends on the particular employment of the device.

As noted above, currently no lifetime-reducing dopants are used in APDs due to the deleterious effect of common dopants on APD leakage. Silicon APDs thus present a compromise involving relatively slow switching speeds with acceptable leakage.

## Summary of the Invention

The invention is set forth in Claim 1.

Features of this invention are to provide a silicon APD having fast switching times, an APD having fast switching times and with low dark current, and an APD exhibiting electrical stability at temperatures less than about 300°C.

In accordance with the present invention, an avalanche photodiode includes a first semiconductor layer doped to exhibit p type conductivity and a second semiconductor absorption layer doped to exhibit n type conductivity. The first and second semiconductor absorption layers are disposed adjacent to one another to form a p-n junction. Each of the first and second semiconductor absorption layers have a carrier-lifetime reducing dopant distributed therethrough, the lifetime-reducing dopant exhibiting relatively large carrier cross-sections and causing each of the doped semiconductor layers to have at least one recombination center located between about 100 mV to 400 mV from the center of the bandgap. Platinum is advantageously used as the carrier-lifetime reducing dopant. Additionally platinum-doped semiconductor materials are electrically stable at temperatures less than about 300°C.

The APD further includes a first conductive layer doped to exhibit p+ conductivity disposed over the surface of the first (p type) semiconductor layer opposite the surface of the first semiconductor layer forming the p-n junction, and a second conductive layer doped to exhibit n+ conductivity disposed over the surface of the second (n-type) semiconductor layer opposite the p-n junction. First and second contact pads are advantageously disposed respectively on the first and second conductive layers to provide electrical connections to components external to the APD. The sidewalls of the first and second semiconductor layers are typically beveled such that the sidewalls in the vicinity of the p-n junction have a curved contour.

## Brief Description of the Drawings

The features of the invention believed to be novel are set forth with particularity in the appended claims. The invention itself, however, both as to organization and method of operation, together with further objects and advantages thereof, may best be understood by reference to the following description in conjunction with the accompanying drawings in which like characters represent like parts throughout the drawings, and in which:

Figure 1 is a cross-sectional view of an APD fabricated in accordance with the present invention.

Figure 2 is a graph representing the variation of carrier lifetime with the position of the Fermi energy level in each semiconductor layer doped with a lifetime-reducing dopant; curves representing relative single recombination center values for silicon doped with gold (Au) and silicon doped with platinum (Pt) are illustrated.

## Detailed Description of the Invention

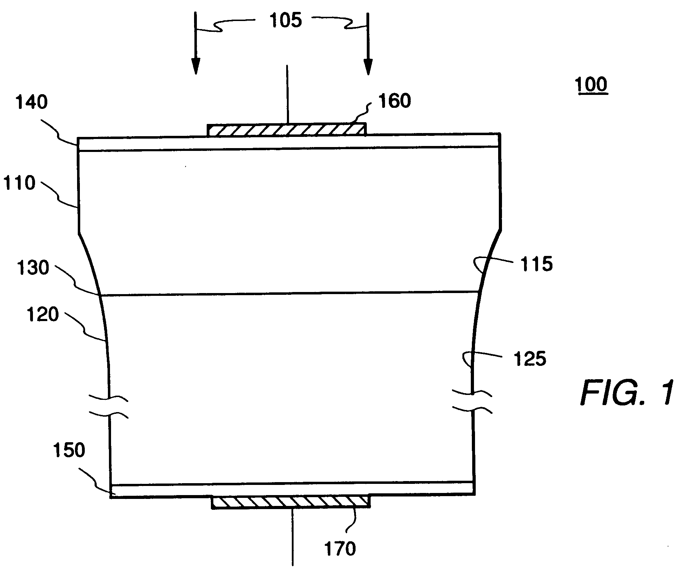

Figure 1 illustrates an avalanche photodiode (APD) 100 in accordance with the present invention. APD 100 comprises a first semiconductor layer 110 and a second semiconductor layer 120 which are adjacent to one another, forming a p-n junction 130 where the two materials adjoin or abut. Typically APD 100 is oriented so that incident light beams 105 enter and are absorbed in first semiconductor layer 120.

First semiconductor layer 110 advantageously comprises substantially intrinsic silicon and is doped with a dopant, such as gallium, to exhibit p type conductivity, and typically has a thickness of between about 20 μm and 100 μm. Second semiconductor layer 120 advantageously comprises substantially intrinsic silicon and is doped to exhibit n-type conductivity, and typically has a thickness between about 80 μm and 160 μm. Second

semiconductor layer is advantageously neutron transmutation doped so that it exhibits the desired n-type conductivity. In practice it is common that a wafer of intrinsic silicon from which the first and second semiconductor layer will be formed is entirely neutron transmutation doped to exhibit n type conductivity; a p type gallium dopant is then diffused into a portion of the wafer to form the first semiconductor layer exhibiting p type conductivity. Sidewalls 115, 125 of first and second semiconductor layers respectively further advantageously have a curved contour at least in the vicinity of p-n junction 130 in order to minimize premature breakdown and surface leakage in the device.

APD 100 further comprises a first conductive layer 140 that is doped to exhibit p+ conductivity and is disposed over the surface of first semiconductor layer 110 that is opposite p-n junction 130. Dopants in first conductive layer 140 are also advantageously selected to provide the desired light sensitivity, for example blue sensitivity, for the incident light. A second conductive layer 150 is doped to exhibit n+ conductivity and is disposed over the surface of second semiconductor layer 120 opposite p-n junction 130. APD 100 is electrically coupled to components (not shown) for reading and recording charge produced in the APD in response to incident light by a first contact pad 160 in ohmic contact with first conductive layer 140 and by a second contact pad 170 in ohmic contact with second conductive layer 150.

In accordance with this invention, first and second semiconductor layers 110, 120 further include a carrier lifetime-reducing dopant. As used herein, "carrier lifetime-reducing" refers to a dopant that reduces both the low-level lifetime and the high-level lifetime of the semiconductor material through which the dopant is distributed. The carrier lifetime-reducing dopant further exhibits deep levels having relatively large carrier cross-sections. The deep levels refer to the characteristic of the dopant, when distributed in the semiconductor layer, to have an energy level near the center of the bandgap. The carrier lifetime-reducing dopant is advantageously platinum (Pt).

The platinum dopant is distributed through the semiconductor material, for example by diffusion, so as to have a selected dopant concentration in the range between about $10^{13}$ atoms/cm$^3$ and $10^{16}$ atoms/cm$^3$. The semiconductor material doped with the carrier lifetime reducing dopant has at least one recombination center located between about 100 mV and 400 mV from the center of the bandgap. Thus, both first and second semiconductor layers 110, 120, when doped in accordance with this invention, exhibit at least one recombination level between about 100 mV and 450 mV from the center of the energy bandgap for that layer. Typically only one recombination level is used in analysis even when multiple recombination levels occur.

Platinum is advantageously used as the lifetime-reducing dopant as it improves APD performance in several ways. In particular, platinum doping provides much better performance than gold, which is the most common lifetime-reducing dopant used in the power device art. For example, platinum reduces both high and low level carrier lifetimes while not adversely affecting the bulk leakage of the APD (therefore not increasing the dark current of the device). By contrast, sufficient amounts of gold can reduce low and high level lifetimes, but only at the cost of higher bulk leakage from the device, which makes the device undesirable for use as a low leakage APD. The high level lifetime is a function of the sum of $\tau_{po} + \tau_{no}$, and thus the turn off at high levels of excitation is typically slower than at low levels of excitation. The ratio of the values of $\tau_{po}$ to $\tau_{no}$ for gold is about 1:100; thus, no matter how much gold is diffused or otherwise distributed through the silicon, the sum of the two lifetimes remains large and consequently results in relatively slow switching times in response to a high flux of incident light. By contrast, it has been experimentally observed that the ratio of $\tau_{po}$ to $\tau_{no}$ for platinum is in the range of 1:1 to 1:10, and thus the turn off time at strong levels of excitation is faster in a platinum-doped device than in a gold-doped device.

The distribution of platinum through first and second semiconductor layer 110, 120 to the selected dopant concentration further results in a higher space charge lifetime than that of a gold doped semiconductor material. Consequently, bulk leakage, which is inversely proportional to the space charge lifetime, is much less for a platinum doped semiconductor material than for a gold doped semiconductor material.

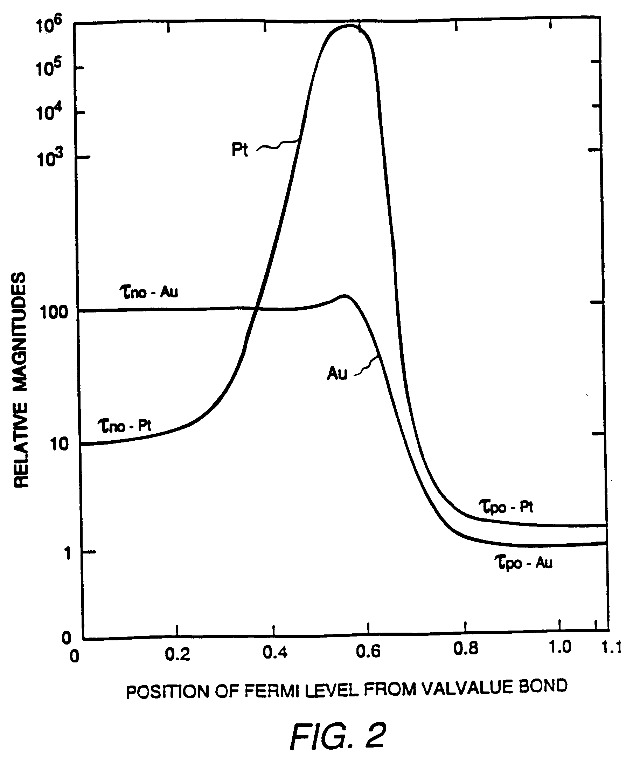

The graph of Figure 2 illustrates representative curves for gold and platinum, showing representative relative magnitudes of $\tau_{po}$ and $\tau_{no}$ and illustrates the difference in space charge lifetime for a semiconductor material doped with gold and doped with platinum. For example, space charge lifetime is determined by $E_r - E_i$ for the doped material (i.e., the separation in between the recombination level and the intrinsic level). For platinum-doped semiconductor materials, the dominant recombination centers are significantly displaced from the center of the bandgap, i.e., about 340 mV, as shown by the following equations for platinum-doped silicon:

$$E_r = E_c - 0.22 \quad \text{(Eqn 1 - 1)}$$
$$E_i = E_c - 1.12/2 = E_c - 0.56 \quad \text{(Eqn 1 - 2)}$$

$$E_r - E_i = (E_c - 0.22) - (E_c - 0.56) = \qquad \text{(Eqn 1-3)}$$

$$= 0.56 - 0.22 = 0.34 \text{ eV} = 340 \text{ mV}$$

(Ec refers to the conduction band level; for intrinsic silicon; 0.56 is one-half the bandgap, and $E_r$ for platinum is 0.22 with respect to the conduction band.)

By contrast, $E_r - E_i$ for gold is approximately zero; thus gold-doped semiconductor material exhibits lower space charge lifetimes and higher bulk leakage than platinum-doped semiconductor material. Platinum-doped semiconductor materials are additionally electrically stable (i.e., the electrical characteristics of the doped material do not change markedly in this temperature range) at temperatures up to about 300°C, whereas gold-doped semiconductor material becomes electrically unstable at temperatures about 150 ° C.

While only certain features of the invention have been illustrated and described herein, many modifications and changes will occur to those skilled in the art. It is, therefore, to be understood that the appended claims are intended to cover all such modifications and changes as fall within the true spirit of the invention.

## Claims

1. An avalanche photodiode (APD) comprising:
   a first semiconductor layer doped to exhibit p type conductivity; and
   a second semiconductor layer doped to exhibit n type conductivity;
   said first and second semiconductor layers being disposed adjacent to one another so as to form a p-n junction;
   each of said first and second semiconductor layers further comprising a carrier lifetime-reducing dopant distributed therethrough to a selected dopant concentration, said carrier-lifetime reducing dopant having deep levels exhibiting relatively large carrier cross-sections, each of the lifetime-reducing doped semiconductor layers having at least one recombination center located between about 100 mV and 450 mV from the center of the respective bandgap of each of said semiconductor layers.

2. The APD of claim 1 wherein said first and second semiconductor layers each comprise silicon.

3. The APD of claim 2 wherein said carrier lifetime-reducing dopant comprises platinum (Pt).

4. The APD of claim 3 wherein said selected dopant concentration of platinum in each of said first and second semiconductor layers is between about $10^{13}$ atom/cm$^3$ and $10^{16}$ atoms/cm$^3$.

5. The APD of claim 4 wherein the p type dopant in said first semiconductor layer comprises gallium.

6. The APD of claim 4 wherein said second semiconductor layer comprises neutron transmutation doped silicon.

7. The APD of claim 4 wherein said first semiconductor layer has a thickness between about 20 $\mu$m and about 100 $\mu$m.

8. The APD of claim 7 wherein said second semiconductor layer has a thickness between about 80 $\mu$m and about 160 $\mu$m.

9. The APD of claim 4 wherein the sidewalls of said first and second semiconductor layers adjoining said p-n junction have a curved contour.

10. The APD of claim 4 and further comprising:
    a first conductive layer doped to exhibit p+ conductivity and disposed over the surface of said first semiconductor layer opposite the p-n junction surface; and
    a second conductive layer doped to exhibit n+ conductivity and disposed over the surface of said second semiconductor layer opposite the p-n junction surface.

11. The APD of claim 10 and further comprising:

an electrically conductive first contact pad in ohmic contact with said first conductive layer; and
an electrically conductive second contact pad in ohmic contact with said second conductive layer.

*FIG. 1*

EP 0 571 142 A1

FIG. 2

European Patent
Office

**EUROPEAN SEARCH REPORT**

Application Number

EP  93 30 3751
Page  1

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5 ) |
|---|---|---|---|
| Y | APPLIED PHYSICS LETTERS. vol. 30, no. 2, 15 January 1977, NEW YORK US pages 118 - 120 GELEZUNAS ET AL. 'UNIFORM LARGE-AREA HIGH-GAIN SILICON AVALANCHE RADIATION DETECTORS FROM TRANSMUTATION DOPED SILICON' * the whole document * | 1,2,3,5, 7,8 | H01L31/107 H01L31/0288 |
| Y | RADIATION PROTECTION DOSIMETRY -ENVIRONMENTAL AND HUMAN RISKS OF TRITIUM-PROCEEDINGS OF A WORKSHOP vol. 16, no. 1/2, 17 February 1986, KARLSRUHE, FRG pages 527 - 530 DIXON ET AL. 'GOLD AND PLATINUM DOPED RADIATION RESISTANT SILICON DIODE DETECTORS' * abstract * | 1,2,3,5, 7,8 | |
| A | US-A-5 021 854 (HUTH) * the whole document * | 1,2,6,9, 10,11 | **TECHNICAL FIELDS SEARCHED (Int. Cl.5 )** H01L |
| A | NUCLEAR INSTRUMENTS AND METHODS vol. 196, 1982, HOLLAND pages 143 - 148 KIM ET AL. 'NEUTRON TRANSMUTATION DOPED SILICON DETECTORS' * the whole document * | 1,6 | |
| A | GB-A-1 215 557 (NIPPON ELECTRIC COMPANY LIMITED) * the whole document * | 1,2 | |

-/--

The present search report has been drawn up for all claims

| Place of search | Date of completion of the search | Examiner |
|---|---|---|
| THE HAGUE | 31 AUGUST 1993 | LINA F. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P0401)

EP 0 571 142 A1

**European Patent Office**

**EUROPEAN SEARCH REPORT**

Application Number

EP    93 30 3751
Page 2

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| A | MATERIALS RESEARCH SOCIETY SYMPOSIA PROCEEDINGS vol. 27, 1984, NEW-YORK,US pages 537 - 542 MOGRO-CAMPERO ET AL. 'CARRIER LIFETIME REDUCTION BY ION IMPLANTATION INTO SILICON' * the whole document * ----- | 1,2 | |
| | | | TECHNICAL FIELDS SEARCHED (Int. Cl.5) |

The present search report has been drawn up for all claims

| Place of search | Date of completion of the search | Examiner |
|---|---|---|
| THE HAGUE | 31 AUGUST 1993 | LINA F. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P0401)